# EUROPÄISCHE PATENTSCHRIFT

(11) **EP 2 564 445 B1**
(45) Veröffentlichungstag und Bekanntmachung des Hinweises auf die Patenterteilung: **13.06.2018**
(21) Anmeldenummer: 11738947.8
(22) Anmeldetag: 20.04.2011
(51) Int. Cl.: H01L 51/52, B82Y 20/00

(54) **ANORDNUNG ZUM ERZEUGEN ELEKTROMAGNETISCHER STRAHLUNG**
ARRANGEMENT FOR GENERATING ELECTROMAGNETIC RADIATION
DISPOSITIF DE GÉNÉRATION DE RAYONNEMENT ÉLECTROMAGNÉTIQUE

(30) Priorität: 30.04.2010 DE 102010019660
(43) Veröffentlichungstag der Anmeldung: 06.03.2013
(73) Patentinhaber: Humboldt Universität zu Berlin, 10099 Berlin (DE); Forschungsverbund Berlin E.V., 12489 Berlin (DE)
(72) Erfinder: HENNEBERGER, Fritz, 16515 Oranienburg OT Lehnitz (DE); RIECHERT, Henning, 85521 Ottobrunn (DE); KOCH, Norbert, 14197 Berlin (DE)
(74) Vertreter: Fischer, Uwe
(86) Internationale Anmeldenummer: PCT/DE2011/050011
(87) Internationale Veröffentlichungsnummer: WO 2011/134464

(56) Entgegenhaltungen:
- WO-A2-2009/003150
- US-A1- 2005 227 391
- US-A1- 2005 269 576

## Beschreibung

Die Erfindung bezieht sich auf eine Anordnung mit den Merkmalen gemäß dem Oberbegriff des Patentanspruchs 1.

Eine derartige Anordnung ist in der US-Offenlegungsschrift US2005/0269576 A1 beschrieben. Bei der vorbekannten Anordnung werden Ladungsträger an der Nadelspitze von Nanonadeln emittiert.

Eine andere Anordnung ist in der Druckschrift "Dual luminescence from organic/inorganic hybrid p-n-junction lightemitting diodes" (Jong H. Na, M. Kitamura, M. Arita, Y. Arakawa; Applied Physics Letters, 94, 213302, 2009) beschrieben.

Aus der internationalen Patentanmeldung WO 2009/003150 A2 ist eine laterale photovoltaische Struktur mit Mikro- und Nano-Elementen zum Sammeln von photogenerierten Ladungsträgern bekannt.

Der Erfindung liegt die Aufgabe zugrunde, eine Anordnung zum Erzeugen elektromagnetischer Strahlung anzugeben, bei der ein sehr hoher Wirkungsgrad erreicht wird, also das Verhältnis zwischen der erzeugten elektromagnetischen Strahlungsenergie und der zum Anregen dafür nötigen elektrischen Energie möglichst groß ist.

Diese Aufgabe wird erfindungsgemäß gelöst durch eine Anordnung mit den Merkmalen gemäß Patentanspruch 1. Erfindungsgemäß ist unter anderem vorgesehen, dass die Ladungsträgerinjektionszone durch eine quer zur Zylinderlängsachse des Halbleiterzylinders angeordnete Zylinderschicht gebildet ist und das organische Material einen optisch aktiven Ring bildet, der radial außen an dieser Zylinderschicht des Halbleiterzylinders, mindestens in Höhe der Ladungsträgerinjektionszone, aufliegt.

Ein wesentlicher Vorteil der erfindungsgemäßen Anordnung ist darin zu sehen, dass Ladungsträger mit einem sehr hohen Wirkungsgrad in das optisch aktive organische Material (z. B. organisches Halbleitermaterial) eindringen und dort unter Emission elektromagnetischer Strahlung rekombinieren können, da das optisch aktive Material außen auf der Mantelfläche des Halbleiterzylinders aufliegt und somit Elektron-Lochpaare aus der Ladungsträgerinjektionszone des Halbleiterzylinders sehr effizient in das organische Material übertreten können.

Zwischen der Ladungsträgerinjektionszone und der Mantelfläche des Halbleiterzylinders bzw. zwischen der Ladungsträgerinjektionszone und dem organischen Material kann ein direkter elektronischer Kontakt bestehen, jedoch ist dies nicht zwingend nötig. Es ist ausreichend, wenn die Ladungsträgerinjektionszone und das organische Material mittelbar in Kontakt stehen und die Ladungsträger aufgrund ihrer Diffusionslänge die Möglichkeit haben, die Nähe der Mantelfläche und des organischen Materials durch Diffusion zu erreichen und durch nicht strahlenden Energietransfer in das organische Material einzudringen.

Vorzugsweise weist der Halbleiterzylinder mindestens eine Zylinderschicht aus p-dotiertem anorganischen Material und mindestens eine Zylinderschicht aus n-dotiertem anorganischen Material auf, und die Ladungsträgerinjektionszone liegt vorzugsweise zwischen der p-dotierten und der n-dotierten Zylinderschicht. Eine solche pn-Struktur ermöglicht die Injektion von Ladungsträgern durch das Anlegen einer Flussspannung.

Auch wird es als vorteilhaft angesehen, wenn der Halbleiterzylinder mindestens eine schwach dotierte oder undotierte Zylinderschicht aufweist und die Ladungsträgerinjektionszone in der schwach dotierten oder undotierten Zylinderschicht liegt. Beispielsweise kann die Ladungsträgerinjektionszone in dem i-Gebiet einer pin-Diode angeordnet sein bzw. können die p-dotierte, die n-dotierte und die schwach oder undotierte Zylinderschicht eine pin-Diode bilden.

Das organische Material besteht vorzugsweise aus einem konjugierten Polymer oder konjugierten Molekülen oder weist ein solches bzw. solche zumindest auch auf. Die konjugierten Polymere oder die konjugierten Moleküle können beispielsweise Monomere oder kovalent verknüpfte Einheiten aus Thiophen, Phenylen, Pheylenvinylen, Fluoren, Quinoxalin, Arylamin, Pyridin bzw. organische Übergangs- oder Schwermetallkomplexe enthalten.

Um eine Diffusion aller in die Ladungsträgerinjektionszone injizierten Ladungsträger zur Mantelfläche und anschließenden Energietransfer in das organische Material hinein zu ermöglichen, wird es als vorteilhaft angesehen, wenn der Zylinderdurchmesser des Halbleiterzylinders kleiner als die Diffusionslänge von in der Ladungsträgerinjektionszone befindlichen Ladungsträgern (Elektronen und Löcher) ist.

Mit Blick auf eine Emission sichtbaren Lichts wird es als vorteilhaft angesehen, wenn die Bandlücke des anorganischen Halbleitermaterials in der Ladungsträgerinjektionszone zwischen 2,5 und 3,3 eV liegt.

Beispielsweise kann es sich bei dem Halbleitermaterial um ein (In,Ga)N-Material handeln.

Zur Ladungsträgerbündelung kann der Halbleiterzylinder eine Quantum-Well-Struktur mit zumindest einer Zylinderschicht mit kleiner Bandlücke und zumindest zwei benachbarten Zylinderschichten mit demgegenüber größerer Bandlücke aufweisen; in diesem Fall wird das organische Material vorzugsweise einen optisch aktiven Ring bilden, der an zumindest einer Zylinderschicht mit geringer Bandlücke radial außen aufliegt.

Eine solche Quantum-Well-Struktur kann beispielsweise aus einem (In,Ga)N/GaN-Halbleitermaterial bestehen.

Auch ist es möglich, dass das organische Material die gesamte Mantelschicht des Halbleiterzylinders bedeckt. Eine Emission elekromagnetischer Strahlung wird in diesem Fall überwiegend bzw. ausschließlich in dem Bereich bzw. in den Bereichen auftreten, der bzw. die an eine Ladungsträgerinjektionszone angrenzen, weil die Ladungsträgerinjektionszonen Ladungsträger zur Rekombination zur Verfügung stellen.

Die Grund- und Deckfläche des Halbleiterzylinders kann beliebig geformt sein, beispielsweise kreisförmig, oval, quadratisch, rechteckig oder vieleckig.

Durch den Halbleiterzylinder wird vorzugsweise ein Hauptstrompfad gebildet, der sich längs der Zylinderlängsrichtung erstreckt und Ladungsträger in die Ladungsträgerinjektionszone injiziert; in der Ladungsträgerinjektionszone wird sich dadurch ein Ladungsträgerdiffusionspfad bilden, der senkrecht zu dem Hauptstrompfad verläuft und Elektron-Lochpaare in die Nähe des organischen Materials transportiert werden und anschließend in dieses durch nicht strahlenden Energietransfer übergehen.

Die Erfindung bezieht sich darüber hinaus auf ein Verfahren mit den Merkmalen gemäß Patentanspruch 9.

Bezüglich der Vorteile des erfindungsgemäßen Verfahrens sei auf die obigen Ausführungen im Zusammenhang mit der erfindungsgemäßen Anordnung verwiesen, da die Vorteile des erfindungsgemäßen Verfahrens denen der erfindungsgemäßen Anordnung im Wesentlichen entsprechen.

Gemäß einer bevorzugten Ausgestaltung des Verfahrens ist vorgesehen, dass auf einem Substrat eine Keimfläche (Wachstumskeimfläche) aufgebracht wird und der Halbleiterzylinder auf der Keimfläche durch Abscheiden - beispielsweise im Rahmen eines selbstorganisierten Nanodraht-Wachstumsmechanismus - aufgewachsen wird. Bevorzugt wird der Halbleiterzylinder auf der Keimfläche mittels eines MBE-Verfahrens (MBE: Molekularstrahlepitaxie) aufgewachsen.

Die Mantelfläche des Halbleiterzylinders kann beispielsweise ganzflächig mit einer Schicht aus dem organischen Material bedeckt werden.

Auch können auf dem Substrat zwei oder mehr Halbleiterzylinder hergestellt werden und der Bereich zwischen den Halbleiterzylindern mit dem organischen Material gefüllt werden.

Alternativ können die Mantelflächen der Halbleiterzylinder ganzflächig mit einer Schicht aus dem organischen Material bedeckt werden und der Bereich zwischen den bedeckten Halbleiterzylindern mit einem transparenten Füllmaterial gefüllt werden.

Die Erfindung wird nachfolgend anhand von Ausführungsbeispielen näher erläutert; dabei zeigen beispielhaft
- Figur 1: ein erstes Ausführungsbeispiel für eine erfindungsgemäße Anordnung mit zwei Halbleiterzylindern, deren Mantelfläche jeweils von einem optisch aktiven Ring radial eingeschlossen wird,
- Figur 2: ein zweites Ausführungsbeispiel für eine erfindungsgemäße Anordnung, bei der organisches Material die gesamte Mantelfläche der Halbleiterzylinder bedeckt,
- Figur 3: ein drittes Ausführungsbeispiel für eine erfindungsgemäße Anordnung, bei der zwischen Halbleiterzylindern und Substrat eine Pufferschicht angeordnet ist,
- Figur 4: ein viertes Ausführungsbeispiel für eine erfindungsgemäße Anordnung, bei der organisches Material ganzflächig auf den Mantelflächen der Halbleiterzylinder befindlich ist und zwischen Halbleiterzylindern und Substrat eine Pufferschicht vorhanden ist, und
- Figur 5: ein Ausführungsbeispiel für ein Verfahren zum Herstellen einer erfindungsgemäßen Anordnung.

Der Übersicht halber werden in den Figuren für identische oder vergleichbare Komponenten stets dieselben Bezugszeichen verwendet.

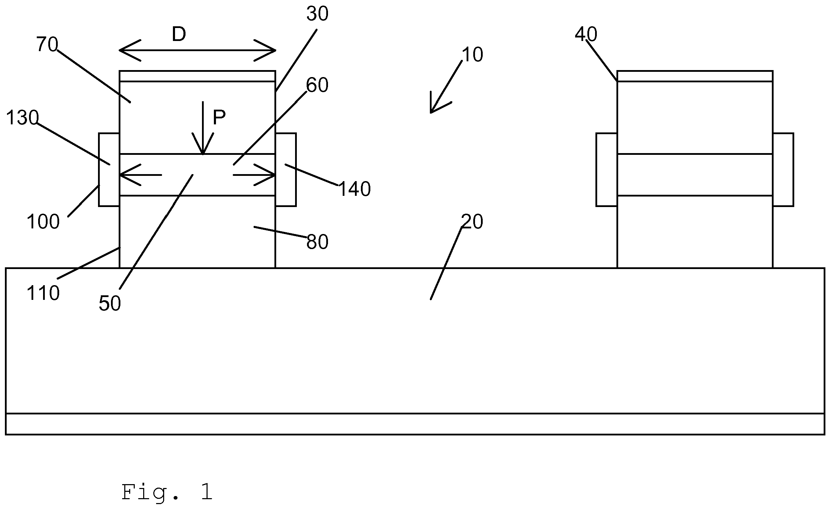

In der Figur 1 ist ein Ausführungsbeispiel für eine Anordnung 10 zum Erzeugen elektromagnetischer Strahlung dargestellt. Man erkennt ein Substrat 20, auf dem eine Vielzahl an Halbleiterzylindern angeordnet ist, von denen in der Figur 1 beispielhaft zwei gezeigt und mit den Bezugszeichen 30 und 40 gekennzeichnet sind.

Die beiden Halbleiterzylinder 30 und 40 können beispielsweise baugleich sein, so dass nachfolgend beispielhaft ausschließlich der in der Figur 1 linke Halbleiterzylinder 30 näher beschrieben wird.

Man erkennt in der Figur 1 eine Ladungsträgerinjektionszone 50, die durch eine schwach- oder undotierte Zylinderschicht 60 des Halbleiterzylinders 30 gebildet ist. Die Zylinderschicht 60 wird von zwei hoch- oder zumindest höher-dotierten Zylinderschichten 70 und 80 eingeschlossen. Die Zylinderschicht 70 kann beispielsweise p-dotiert und die Zylinderschicht 80 n-dotiert sein, so dass die drei Zylinderschichten 60, 70 und 80 eine Pin-Diodenstruktur bilden.

Um eine hohe Ladungsträgerdichte in der Ladungsträgerinjektionszone 50 bzw. der Zylinderschicht 60 zu erreichen, ist der Bandabstand in der Zylinderschicht 60 vorzugsweise kleiner als der Bandabstand in den benachbarten Zylinderschichten 70 und 80. Beispielsweise bestehen die Zylinderschichten 70 und 80 aus Galliumnitrid (GAN) und die Zylinderschicht 60 aus Indiumgalliumnitrid (InGaN).

In der Figur 1 lässt sich darüber hinaus ein optisch aktiver Ring 100 erkennen, der aus einem optisch aktiven organischen Material (z. B. organischen Halbleitermaterial) besteht und radial außen auf der Mantelfläche 110 des Halbleiterzylinders 30 aufliegt. Die Position des optisch aktiven Rings 100 ist vorzugsweise derart gewählt, dass dieser zumindest abschnittsweise außen auf der Ladungsträgerinjektionszone 50 bzw. der Zylinderschicht 60 aufliegt.

Der Durchmesser D des Halbleiterzylinders 30 ist vorzugsweise derart gewählt, dass er kleiner als die Diffusionslänge von in die Ladungsträgerinjektionszone 50 injizierten Ladungsträgern ist. Eine solche Dimensionierung des Halbleiterzylinders 30 führt dazu, dass bei Anlegen einer elektrischen Spannung an die durch die Zylinderschichten 60, 70 und 80 gebildete Pin-Diode in die Ladungsträgerzone 50 Ladungsträger injiziert werden, die innerhalb der Ladungsträgerinjektionszone 50 senkrecht zum Hauptstrompfad P diffundieren und den optisch aktiven Ring 100 erreichen können. Dies ermöglicht es den in die Ladungsträgerzone 50 injizierten Ladungsträgern, durch nicht strahlenden Energietransfer in das organische Material 130 des optisch aktiven Ringes 100 einzutreten und dort unter Emission elektromagnetischer Strahlung zu rekombinieren. Im Falle einer solchen Rekombination wird der optisch aktive Ring einen Strahlungsring bilden, der in der Figur 1 mit dem Bezugszeichen 140 gekennzeichet ist.

Bei dem Ausführungsbeispiel gemäß Figur 1 ist die Ladungsträgerinjektionszone 50 durch eine einzige schwach- oder undotierte Zylinderschicht 60 gebildet, deren Bandabstand kleiner als der Bandabstand der beiden benachbarten Zylinderschichten 70 und 80 ist. Die drei Zylinderschichten 60, 70 und 80 bilden somit eine Quantum-Well-Struktur mit einer einzigen Schicht geringeren Bandabstands. Alternativ kann die Ladungsträgerinjektionszone 50 auch durch eine Multi-Quantum-Well-Struktur gebildet sein, bei der eine Mehrzahl an Schichten unterschiedlicher Bandabstände aneinandergrenzen, um eine besonders effiziente Ladungsträgerbündelung entlang der Hauptstromrichtung P im Bereich des optisch aktiven Ringes 100 zu erreichen.

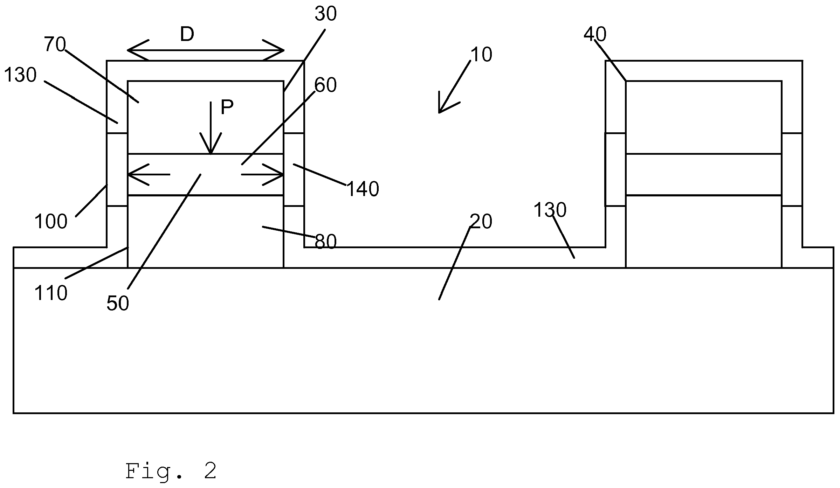

Die Figur 2 zeigt beispielhaft ein Ausführungsbeispiel für eine Anordnung 10 zum Erzeugen elektromagnetischer Strahlung, bei der optisch aktives organisches Material 130 ganzflächig auf der Mantelfläche 110 der Halbleiterzylinder 30 und 40 aufgetragen ist. Im Übrigen entspricht die Anordnung 10 gemäß Figur 2 der Anordnung gemäß Figur 1.

Im Betrieb der Anordnung 10 werden durch Anlegen einer elektrischen Spannung an die durch die Zylinderschichten 60, 70 und 80 gebildete Pin-Diodenstruktur Ladungsträger in die Ladungsträgerinjektionszone 50 injiziert, die lateral - senkrecht zur Hauptstrompfadrichtung P - nach außen diffundieren und in das organische Material 130 durch nicht strahlenden Energietransfer eintreten und dort unter Emission elektromagnetischer Strahlung rekombinieren.

Da aufgrund der Ladungsträgerbündelung in der Ladungsträgerinjektionszone 50 die Ladungsträgerpaare vornehmlich im Bereich der Ladungsträgerzone 50 durch die Mantelfläche 110 hindurch in das organische Material 130 eindringen werden, wird dort die Ladungsträgerdichte besonders groß und die Emission elektromagnetischer Strahlung besonders groß sein. Es wird sich somit in dem optisch aktiven organischen Material 130 ein Strahlungsring bilden, der die elektromagnetische Strahlung ausstrahlt. Der Strahlungsring ist in der Figur 2 mit dem Bezugszeichen 140 gekennzeichnet.

Obwohl also bei dem Ausführungsbeispiel gemäß Figur 2 die gesamte Mantelfläche 110 der Halbleiterzylinder 30 und 40 mit optisch aktivem organischem Material 130 bedeckt ist, wird nur ein relativ kleiner Abschnitt der auf der Mantelfläche 110 befindlichen Schicht tatsächlich elektromagnetische Strahlung erzeugen.

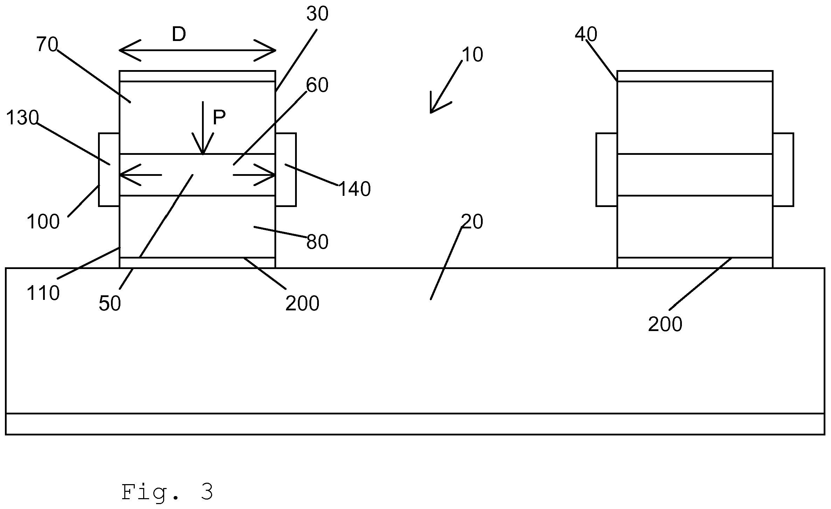

In der Figur 3 ist beispielhaft eine Anordnung 10 zum Erzeugen elektromagnetischer Strahlung gezeigt, bei der auf der Mantelfläche 110 der Halbleiterzylinder 30 und 40 jeweils ein optisch aktiver Ring 100 aus optisch aktivem organischen Material 130 gebildet ist. Im Unterschied zu dem Ausführungsbeispiel gemäß Figur 1 sind die Halbleiterzylinder 30 und 40 nicht unmittelbar auf dem Substrat 20 aufgesetzt, sondern von dem Substrat 20 durch eine Pufferschicht 200 getrennt. Die Funktion einer solchen Pufferschicht kann beispielsweise dazu dienen, als Keimfläche während eines Abscheidungsprozesses zu wirken, durch den die Halbleiterzylinder 30 und 40 auf dem Substrat 20 aufgewachsen werden.

Im Übrigen entspricht das Ausführungsbeispiel gemäß Figur 3 dem Ausführungsbeispiel gemäß Figur 1.

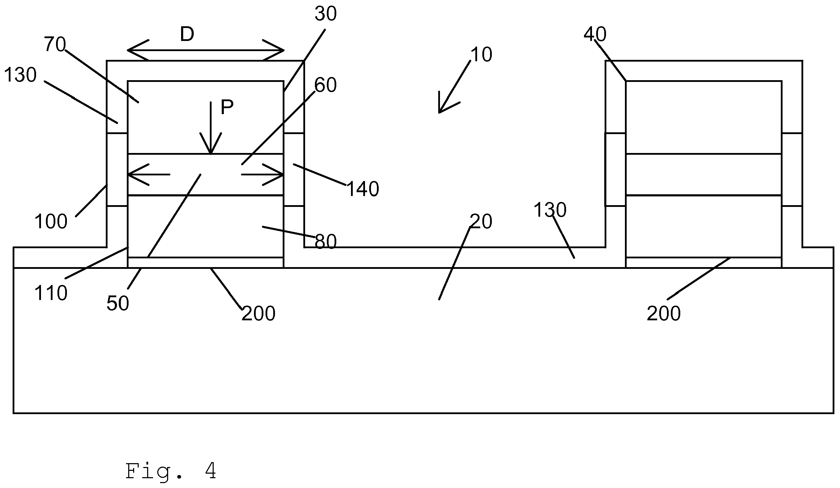

Die Figur 4 zeigt beispielhaft ein Ausführungsbeispiel für eine Anordnung 10 zum Erzeugen elektromagnetischer Strahlung, bei dem das optisch aktive organische Material 130 auf der gesamten Mantelfläche 110 der Halbleiterzylinder 30 und 40 aufgebracht ist und bei dem zusätzlich zwischen den Halbleiterzylindern 30 und 40 und dem Substrat 20 eine Pufferschicht 200 vorhanden ist. Die Pufferschicht 200 fördert - ebenso wie bei dem Ausführungsbeispiel gemäß Figur 3 - ein Wachstum der Halbleiterzylinder 30 und 40 auf dem Substrat 20. Im Übrigen wird auf die obigen Ausführungen im Zusammenhang mit der Figur 2 verwiesen.

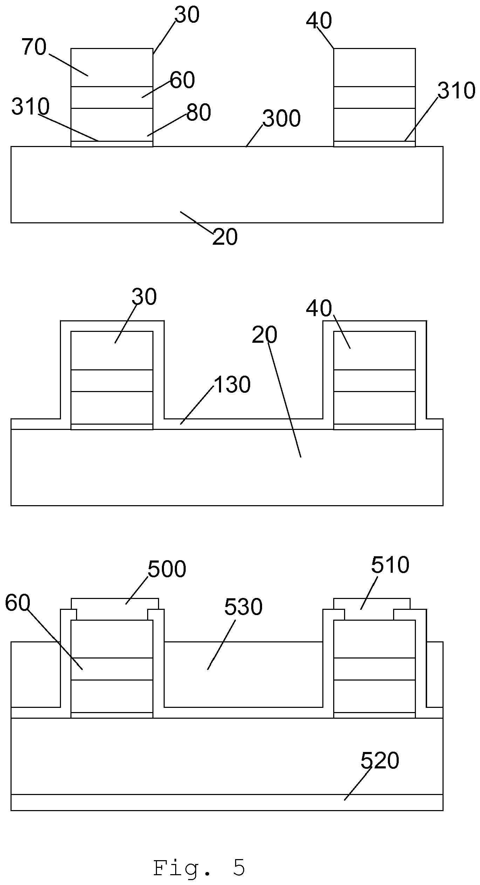

In der Figur 5 ist beispielhaft ein Verfahren zum Herstellen der Anordnung 10 gemäß Figur 4 dargestellt. Man erkennt ein Substrat 20, auf dessen Oberfläche 300 zunächst eine Wachstumskeimschicht aufgebracht wird. Die Wachstumskeimschicht wird strukturiert, so dass Wachstumskeimflächen 310 gebildet werden, auf denen das Wachstum der aufzuwachsenden Halbleiterzylinder 30 und 40 erfolgen soll. Die Funktion der Wachstumskeimflächen 310 besteht darin, ein selbst organisiertes Nanodrahtwachstum während eines MBE-Abscheidungsprozesses auf dem Substrat 20 zu ermöglichen (vgl. "Axial and radial growth of Ni-induced GaN nanowires", L. Geelhaar, C. Cheze, W. M. Weber, R. Averbeck, H. Riechert, Th. Kehagias, Ph. Komninou, G. P. Dimitrakopulos, Th. Karakostas, , Appl. Phys. Lett. 91 (2007) 093113; "Ferromagnet-semiconductor nanowire coaxial heterostructures grown by molecular-beam epitaxy", M. Hilse, Y. Takagaki, J. Herfort, M. Ramsteiner, C. Herrmann, S. Breuer, L. Geelhaar, H. Riechert, Appl. Phys. Lett. 95 (2009) 133126).

In einem nachfolgenden Prozessschritt wird anorganisches Halbleitermaterial, beispielsweise n-dotiertes Galliumnitrid auf dem Substrat 20 aufgewachsen, dabei kommt es auf den Wachstumskeimflächen 310 zu einem besonders schnellen Wachstum und zur Ausbildung zylindrischer Strukturen.

Nachfolgend werden weitere Zylinderschichten, beispielsweise eine schwach- oder undotierte Zylinderschicht 60 aus Indiumgalliumnitrid und eine p-dotierte Zylinderschicht 70 aus p-dotiertem Galliumnitrid im Rahmen des bereits erwähnten selbst-organisierten Nanonadelwachstumsmechanismus abgeschieden. Es bildet sich somit die in der Figur 5 (obere Darstellung) gezeigte Struktur.

Anschließend wird optisch aktives organisches Material 130 ganzflächig auf dem Substrat 20 sowie den beiden Halbleiterzylindern 30 und 40 abgeschieden; die resultierende Struktur ist in der Figur 5 (Mitte) dargestellt.

Danach werden die Halbleiterzylinder 30 und 40 mit elektrischen Kontakten 500, 510 und 520 kontaktiert, um eine elektrische Ansteuerung der Halbleiterzylinder 30 und 40 und eine Ladungsträgerinjektion in die Zylinderschicht 60 zu vereinfachen.

Der zwischen den Halbleiterzylindern 30 und 40 vorhandene Bereich kann beispielsweise mit einem transparenten Füllmaterial 530 gefüllt werden. Das transparente Füllmaterial 530 kann beispielsweise mit dem organischen Material 130 identisch sein.

### Bezugszeichenliste

- 10: Anordnung
- 20: Substrat
- 30: Halbleiterzylinder
- 40: Halbleiterzylinder
- 50: Ladungsträgerinjektionszone
- 60: Zylinderschicht
- 70: Zylinderschicht
- 80: Zylinderschicht
- 100: Ring
- 110: Mantelfläche
- 130: organisches Material
- 140: Strahlungsring
- 200: Pufferschicht
- 300: Oberfläche
- 310: Wachstumskeimfläche
- 500: Kontakt
- 510: Kontakt
- 520: Kontakt
- 530: Füllmaterial

- D: Durchmesser
- P: Hauptstrompfad

## Patentansprüche

1. Anordnung (10) zum Erzeugen elektromagnetischer Strahlung, wobei die Anordnung anorganisches Halbleitermaterial und organisches Material (130) aufweist,
mit
- einem Halbleiterzylinder (30, 40) aus anorganischem Halbleitermaterial und
- einer in dem Halbleiterzylinder befindlichen Ladungsträgerinjektionszone (50), wobei
- die Ladungsträgerinjektionszone an die Mantelfläche (110) des Halbleiterzylinders angrenzt,
- das organische Material (130) geeignet ist, im Falle einer Ladungsträgerrekombination elektromagnetische Strahlung zu emittieren, und
- das organische Material auf demjenigen Abschnitt der Mantelfläche des Halbleiterzylinders, an den die Ladungsträgerinjektionszone angrenzt, mittelbar oder unmittelbar aufliegt und Elektron-Lochpaare aus der Ladungsträgerinjektionszone des Halbleiterzylinders in das organische Material, vorzugsweise durch nicht strahlenden Energietransfer, eintreten und dort die Emission elektromagnetischer Strahlung durch Rekombination anregen können,
**dadurch gekennzeichnet, dass**
- die Ladungsträgerinjektionszone durch eine quer zur Zylinderlängsachse des Halbleiterzylinders angeordnete Zylinderschicht (60) gebildet ist und
- das organische Material einen optisch aktiven Ring (100) bildet, der radial außen an dieser Zylinderschicht des Halbleiterzylinders aufliegt.

2. Anordnung nach Anspruch 1,
**dadurch gekennzeichnet, dass**
- der Halbleiterzylinder mindestens eine Zylinderschicht (70) aus p-dotiertem anorganischen Material und mindestens eine Zylinderschicht (80) aus n-dotiertem anorganischen Material aufweist und
- die Ladungsträgerinjektionszone (50) zwischen der p-dotierten und der n-dotierten Zylinderschicht liegt.

3. Anordnung nach einem der voranstehenden Ansprüche,
**dadurch gekennzeichnet, dass**
- der Halbleiterzylinder mindestens eine schwach dotierte oder undotierte Zylinderschicht aufweist und
- die Ladungsträgerinjektionszone (50) in der schwach dotierten oder undotierten Zylinderschicht (60) liegt.

4. Anordnung nach den Ansprüchen 2 und 3, **dadurch gekennzeichnet, dass**
die p-dotierte, die n-dotierte und die schwach oder undotierte Zylinderschicht eine pin-Diode bilden.

5. Anordnung nach einem der voranstehenden Ansprüche,
**dadurch gekennzeichnet, dass**
das organische Material aus einem konjugierten Polymer oder aus konjugierten Molekülen besteht oder ein solches zumindest aufweist. Polymere oder Moleküle beinhalten beispielsweise Monomere oder kovalent verknüpfte Einheiten aus Thiophen, Phenylen, Pheylenvinylen, Fluoren, Quinoxalin, Arylamin, Pyridin bzw. organische Übergangs- oder Schwermetallkomplexe.

6. Anordnung nach einem der voranstehenden Ansprüche,
**dadurch gekennzeichnet, dass**
der Zylinderdurchmesser (D) des Halbleiterzylinders kleiner als die Diffusionslänge von in der Ladungsträgerinjektionszone befindlichen Ladungsträgern ist.

7. Anordnung nach einem der voranstehenden Ansprüche,
**dadurch gekennzeichnet, dass**
die Bandlücke des anorganischen Halbleitermaterials in der Ladungsträgerinjektionszone zwischen 2,5 und 3,3 eV liegt.

8. Anordnung nach einem der voranstehenden Ansprüche,
**dadurch gekennzeichnet, dass**
- der Halbleiterzylinder eine Quantum-Well-Struktur mit zumindest einer Zylinderschicht mit kleiner Bandlücke und zumindest zwei benachbarten Zylinderschichten mit demgegenüber größerer Bandlücke aufweist und
- das organische Material einen optisch aktiven Ring bildet, der an zumindest einer Zylinderschicht mit geringer Bandlücke radial außen aufliegt.

9. Verfahren zum Herstellen einer Anordnung (10) zum Erzeugen elektromagnetischer Strahlung, bei dem anorganisches Halbleitermaterial und organisches Material verwendet wird,
wobei
ein Halbleiterzylinder (30, 40) aus anorganischem Halbleitermaterial mit einer darin befindlichen Ladungsträgerinjektionszone (50) gebildet wird, wobei die Ladungsträgerinjektionszone an die Mantelfläche (110) des Halbleiterzylinders angrenzt, und
organisches Material, das bei Ladungsträgerrekombination elektromagnetische Strahlung emittieren kann, mittelbar oder unmittelbar zumindest auf dem Abschnitt der Mantelfläche aufgebracht wird, an den die Ladungsträgerinjektionszone angrenzt,
**dadurch gekennzeichnet, dass**
- die Ladungsträgerinjektionszone durch eine quer zur Zylinderlängsachse des Halbleiterzylinders angeordnete Zylinderschicht (60) gebildet wird und
- das organische Material einen optisch aktiven Ring (100) bildet, der radial außen an dieser Zylinderschicht des Halbleiterzylinders aufliegt.

## Claims

1. An arrangement (10) for generating electromagnetic radiation, wherein the arrangement comprises inorganic semiconductor material and organic material (130),
wherein
- a semiconductor cylinder (30, 40) composed of inorganic semiconductor material and
- a charge carrier injection zone (50) situated in the semiconductor cylinder, wherein
- the charge carrier injection zone adjoins the lateral surface (110) of the semiconductor cylinder,
- the organic material (130) is suitable for emitting electromagnetic radiation in the case of a charge carrier recombination, and
- the organic material bears indirectly or directly on that section of the lateral surface of the semiconductor cylinder which is adjoined by the charge carrier injection zone and electron-hole pairs from the charge carrier injection zone of the semiconductor cylinder can enter into the organic material, preferably by non-radiative energy transfer, and excite there the emission of electromagnetic radiation by recombination,
**characterized in that**
- the charge carrier injection zone is formed by a cylinder layer (60) arranged transversely with respect to the cylinder longitudinal axis of the semiconductor cylinder, and
- the organic material forms an optically active ring (100) bearing radially on the outside of said cylinder layer of the semiconductor cylinder.

2. The arrangement as claimed in claim 1,
**characterized in that**
- the semiconductor cylinder comprises at least one cylinder layer (70) composed of p-doped inorganic material and at least one cylinder layer (80) composed of n-doped inorganic material, and
- the charge carrier injection zone (50) lies between the p-doped and n-doped cylinder layers.

3. The arrangement as claimed in any of the preceding claims,
**characterized in that**
- the semiconductor cylinder comprises at least one weakly doped or undoped cylinder layer, and
- the charge carrier injection zone (50) lies in the weakly doped or undoped cylinder layer (60).

4. The arrangement as claimed in claims 2 and 3,
**characterized in that**
the p-doped, the n-doped and the weakly or undoped cylinder layers form a pin diode.

5. The arrangement as claimed in any of the preceding claims,
**characterized in that**
the organic material consists of or at least comprises a conjugated polymer or conjugated molecules. Polymers or molecules include, for example, monomers or covalently bonded units of thiophene, phenylene, phenylenevinylene, fluorene, quinoxaline, arylamine, pyridine or organic transition or heavy metal complexes.

6. The arrangement as claimed in any of the preceding claims,
**characterized in that**
the cylinder diameter (D) of the semiconductor cylinder is less than the diffusion length of charge carriers situated in the charge carrier injection zone.

7. The arrangement as claimed in any of the preceding claims,
**characterized in that**
the band gap of the inorganic semiconductor material in the charge carrier injection zone is between 2.5 and 3.3 eV.

8. The arrangement as claimed in any of the preceding claims,
**characterized in that**
- the semiconductor cylinder has a quantum well structure comprising at least one cylinder layer having a small band gap and at least two adjacent cylinder layers having a larger band gap by comparison therewith, and
- the organic material forms an optically active ring bearing radially on the outside of at least one cylinder layer having a small band gap.

9. A method for producing an arrangement (10) for generating electromagnetic radiation, wherein inorganic semiconductor material and organic material are used, wherein
- a semiconductor cylinder (30, 40) composed of inorganic semiconductor material with a charge carrier injection zone (50) situated therein is formed, wherein the charge carrier injection zone adjoins the lateral surface (110) of the semiconductor cylinder, and
- organic material which can emit electromagnetic radiation during charge carrier recombination is applied indirectly or directly at least on that section of the lateral surface which is adjoined by the charge carrier injection zone,
**characterized in that**
- the charge carrier injection zone is formed by a cylinder layer (60) arranged transversely with respect to the cylinder longitudinal axis of the semiconductor cylinder, and
- the organic material forms an optically active ring (100) bearing radially on the outside of said cylinder layer of the semiconductor cylinder.

## Revendications

1. Dispositif (10) pour la génération d'un rayonnement électromagnétique, dans lequel le dispositif présente un matériau semi-conducteur inorganique et un matériau organique (130), avec
- un cylindre semi-conducteur (30, 40) en matériau semi-conducteur inorganique et
- une zone d'injection de porteurs de charge (50) se trouvant dans le cylindre semi-conducteur, dans lequel
- la zone d'injection de porteurs de charge est adjacente à la surface latérale (110) du cylindre semi-conducteur,
- le matériau organique (130) est approprié pour émettre un rayonnement électromagnétique dans le cas d'une recombinaison de porteurs de charge, et
- le matériau organique repose directement ou indirectement sur la partie de la surface latérale du cylindre semi-conducteur, à laquelle la zone d'injection de porteurs de charge est adjacente, et des paires électron-trou provenant de la zone d'injection de porteurs de charge du cylindre semi-conducteur pénètrent dans le matériau organique, de préférence par transfert d'énergie non radiant, et peuvent y exciter l'émission d'un rayonnement électromagnétique par recombinaison,
**caractérisé en ce que**
- la zone d'injection de porteurs de charge est formée par une couche de cylindre (60) disposée transversalement à l'axe longitudinal de cylindre du cylindre semi-conducteur et
- le matériau organique forme un anneau optiquement actif (100), qui repose radialement à l'extérieur sur cette couche de cylindre du cylindre semi-conducteur.

2. Dispositif selon la revendication 1, **caractérisé en ce que**
- le cylindre semi-conducteur présente au moins une couche de cylindre (70) en matériau inorganique à dopage p et au moins une couche de cylindre (80) en matériau inorganique à dopage n et
- la zone d'injection de porteurs de charge (50) est située entre les couches de cylindre à dopage p et à dopage n.

3. Dispositif selon l'une quelconque des revendications précédentes, **caractérisé en ce que**
- le cylindre semi-conducteur présente au moins une couche de cylindre faiblement dopée ou non dopée et
- la zone d'injection de porteurs de charge (50) est située dans la couche de cylindre faiblement dopée ou non dopée (60).

4. Dispositif selon les revendications 2 et 3, **caractérisé en ce que** les couches de cylindre à dopage p, à dopage n et les couches de cylindre faiblement dopées ou non dopées forment une diode PIN.

5. Dispositif selon l'une quelconque des revendications précédentes, **caractérisé en ce que** le matériau organique se compose d'un polymère conjugué ou de molécules conjuguées ou présente au moins un tel composant. Les polymères et les molécules contiennent par exemple des monomères ou des unités liées de façon covalente en thiophène, phénylène, phénylènevinylène, fluorène, quinoxaline, arylamine, pyridine ou des complexes organiques de métaux de transition ou lourds.

6. Dispositif selon l'une quelconque des revendications précédentes, **caractérisé en ce que** le diamètre de cylindre (D) du cylindre semi-conducteur est plus petit que la longueur de diffusion de porteurs de charge se trouvant dans la zone d'injection de porteurs de charge.

7. Dispositif selon l'une quelconque des revendications précédentes, **caractérisé en ce que** l'écart énergétique du matériau semi-conducteur inorganique dans la zone d'injection de porteurs de charge se situe entre 2,5 et 3,3 eV.

8. Dispositif selon l'une quelconque des revendications précédentes, **caractérisé en ce que**
- le cylindre semi-conducteur présente une structure à puits quantiques avec au moins une couche de cylindre avec un faible écart énergétique et au moins deux couches de cylindre voisines avec au contraire un plus grand écart énergétique et
- le matériau organique forme un anneau optiquement actif, qui repose radialement à l'extérieur sur au moins une couche de cylindre à faible écart énergétique.

9. Procédé de réalisation d'un dispositif (10) pour la génération d'un rayonnement électromagnétique, dans lequel on utilise un matériau semi-conducteur inorganique et un matériau organique, dans lequel
on forme un cylindre semi-conducteur (30, 40) en matériau semi-conducteur inorganique avec une zone d'injection de porteurs de charge (50) se trouvant dans celui-ci, dans lequel la zone d'injection de porteurs de charge est adjacente à la surface latérale (110) du cylindre semi-conducteur, et
on applique un matériau organique, qui peut émettre un rayonnement électromagnétique en cas de recombinaison de porteurs de charge, directement ou indirectement au moins sur la partie de la surface latérale à laquelle la zone d'injection de porteurs de charge est adjacente,
**caractérisé en ce que**
- on forme la zone d'injection de porteurs de charge par une couche de cylindre (60) disposée transversalement à l'axe longitudinal de cylindre du cylindre semi-conducteur et
- le matériau organique forme un anneau optiquement actif (100), qui repose radialement à l'extérieur sur cette couche de cylindre du cylindre semi-conducteur.
